(19)

**Europäisches Patentamt**
**European Patent Office**
**Office européen des brevets**

(11) **EP 4 346 006 B1**

(12) **EUROPEAN PATENT SPECIFICATION**

(45) Date of publication and mention
of the grant of the patent:
**24.12.2025  Bulletin 2025/52**

(21) Application number: **22855962.1**

(22) Date of filing: **02.05.2022**

(51) International Patent Classification (IPC):
*H01P 7/08* (2006.01)        *H02J 50/12* (2016.01)
*H01F 38/14* (2006.01)       *H03H 7/38* (2006.01)
*H01P 7/10* (2006.01)        *H01P 1/203* (2006.01)
*H02J 50/70* (2016.01)       *H02J 50/00* (2016.01)

(52) Cooperative Patent Classification (CPC):
**H02J 50/005; H01F 38/14; H01P 1/203; H01P 7/08;
H01P 7/10; H02J 50/12; H02J 50/70; H03H 7/38**

(86) International application number:
**PCT/KR2022/006273**

(87) International publication number:
**WO 2023/017960 (16.02.2023 Gazette 2023/07)**

(54) **ANNULAR RESONATOR AND WIRELESS POWER TRANSMISSION DEVICE COMPRISING ANNULAR RESONATOR**

RINGFÖRMIGER RESONATOR UND VORRICHTUNG ZUR DRAHTLOSEN STROMÜBERTRAGUNG MIT RINGFÖRMIGEM RESONATOR

RÉSONATEUR ANNULAIRE ET DISPOSITIF DE TRANSMISSION DE PUISSANCE SANS FIL COMPRENANT UN RÉSONATEUR ANNULAIRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **11.08.2021  KR 20210105920**

(43) Date of publication of application:
**03.04.2024  Bulletin 2024/14**

(73) Proprietor: **Samsung Electronics Co., Ltd.**
**Suwon-si, Gyeonggi-do 16677 (KR)**

(72) Inventors:
• **PARK, Jaehyun**
  **Suwon-si Gyeonggi-do 16677 (KR)**
• **GU, Beomwoo**
  **Suwon-si Gyeonggi-do 16677 (KR)**
• **PARK, Jaeseok**
  **Suwon-si Gyeonggi-do 16677 (KR)**

• **YEO, Sungku**
  **Suwon-si Gyeonggi-do 16677 (KR)**
• **RYU, Youngho**
  **Suwon-si Gyeonggi-do 16677 (KR)**
• **LEE, Kyungwoo**
  **Suwon-si Gyeonggi-do 16677 (KR)**
• **LEE, Jeongman**
  **Suwon-si Gyeonggi-do 16677 (KR)**

(74) Representative: **HGF**
**HGF Limited**
**4th Floor, 1 City Square**
**Leeds LS1 2AL (GB)**

(56) References cited:
**WO-A1-2021/154836        CN-A- 111 971 853
JP-A- 2019 192 691         KR-A- 20170 100 489
US-A1- 2011 193 415        US-A1- 2015 371 771
US-A1- 2017 186 527        US-A1- 2017 373 538
US-A1- 2020 127 363**

## Description

<u>**TECHNICAL FIELD**</u>

The disclosure relates to an annular resonator and a wireless power transmitter including an annular resonator.

<u>**BACKGROUND ART**</u>

Wireless charging technologies use wireless power transmission/reception such that, by simply placing a mobile phone, for example, on a wireless power transmitter (for example, charging pad) without connecting the same to a separate charging connector, the battery of the mobile phone is automatically charged. Such wireless charging technologies are advantageous in that the waterproofing function can be improved because no connectors are necessary to supply power to electronic products, and the portability of electronic devices can be improved because no wired chargers are necessary.

Recent development of wireless charging technologies has been followed by research regarding a method for supplying power from an electronic device (for example, wireless power transmitter) to various other electronic devices (for example, wireless power receiver), thereby charging the same. Wireless charging technologies include an electromagnetic induction type in which coils are used, a resonance type in which resonance is used, and a RF/microwave radiation type in which electric energy is converted to microwaves and then transferred.

Wireless charging technologies using the electromagnetic induction type or resonance type have recently been widespread in connection with electronic devices such as smartphones, for example. If a wireless power transmitting unit (PTU) (for example, wireless power transmitter) and a wireless power receiving unit (PRU) (for example, smartphone or wearable electronic device) contact or approach within a predetermined distance, the battery of the wireless PRU may be charged by a method such as electromagnetic induction or electromagnetic resonance between the transmitting coil or resonator of the wireless PTU and the receiving coil or resonator of the wireless PRU. Several resonator structures are known from US2011/193415A1, WO2021/154836A1, US2017/186527A1 and JP2019192691A.

The above information is presented as background information only to assist with an understanding of the disclosure. No determination has been made, and no assertion is made, as to whether any of the above might be applicable as prior art with regard to the disclosure.

<u>**DETAILED DESCRIPTION OF THE INVENTION**</u>

Technical Problem

The wireless power transmitter or wireless power transmitting unit (PTU) may include a resonator or coil capable of generating an induced magnetic field if an electric current flows according to the resonance type or induction type. The resonator may be configured in various shapes, and characteristics regarding wireless power transmission may vary depending on the shape of the resonator.

For example, if an electric current is made to flow through the resonator, an induced magnetic field may be generated near the resonator, and an electric field (E-field) may be generated together. Power may be transmitted to the wireless PRU or wireless PTU by the induced magnetic field generated near the resonator, but the electric field may not affect power transmission. The electric field generated near the resonator may adversely affect human bodies, and regulations may forbid use of an electronic device that generates a specific intensity of electric field or more. For example, according to the resonance type among the wireless charging types, a relatively large voltage may be applied to the resonator to transmit power to a wireless PRU spaced apart by a predetermined distance or more, and this may undesirably generate a relatively large electric field near the resonator.

Aspects of the disclosure are to address at least the above-mentioned problems and/or disadvantages and to provide at least the advantages described below. Accordingly, an aspect of the disclosure is to provide an annular resonator and a wireless power transmitter including an annular resonator, wherein the annular resonator includes multiple conductors, and power is distributed and supplied to respective conductors, thereby reducing the size of an electric field generated near the resonator.

Another aspect of the disclosure is to provide an annular resonator and a wireless power transmitter including an annular resonator, wherein the annular resonator includes multiple conductors, and the multiple conductors helically intersect with each other so as to form a loop, thereby reducing the size of an electric field generated near the resonator, and guaranteeing that the electric field is generated in a desired direction.

Another aspect of the disclosure is to provide an annular resonator and a wireless power transmitter including an annular resonator, wherein the annular resonator includes multiple conductors, the multiple conductors helically intersect with each other so as to form a loop, and a capacitor is connected in a range in which each conductor is positioned on the inner surface of the annular resonator, thereby reducing the size of an electric field generated near the resonator, and guaranteeing that the electric field is generated in a desired direction.

Additional aspects will be set forth in part in the description which follows and, in part, will be apparent from the description, or may be learned by practice of the presented embodiments.

Technical Solution

In accordance with an aspect of the disclosure, a resonator is provided. The resonator includes a structure including an upper surface, a lower surface, an outer surface, and an inner surface and arranged along an annular shape, a plurality of conductors arranged on the structure, and a plurality of capacitors connected to the plurality of conductors, respectively, wherein each conductor of the plurality of conductors may include a first section arranged on the upper surface of the structure, a second section extending from the first section and arranged on the outer surface of the structure, a third section extending from the second section and arranged on the lower surface of the structure, and a fourth section extending from the third section and arranged on the inner surface of the structure, among the plurality of conductors, a first section of a first conductor, a first section of a second conductor, a first section of a third conductor, and a first section of a fourth conductor may be sequentially arranged along the upper surface of the structure, and among the plurality of conductors, a second section of the second conductor, a second section of the third conductor, a second section of the fourth conductor, and a second section of the first conductor may be sequentially arranged along the outer surface of the structure.

In accordance with another aspect of the disclosure, a resonator is provided. The resonator includes an annular shaped structure, a plurality of conductors arranged in a loop shape along the structure, respectively, and a plurality of capacitors arranged on a surface facing the center of the annular shaped structure to correspond to the plurality of conductors, respectively, wherein each conductor of the plurality of conductors may be helically arranged along the shape of the structure around the structure, and the plurality of conductors may be adjacent to each other and may be alternatively arranged on the same plane or the same curved surface of the structure.

In accordance with another aspect of the disclosure, a wireless power transmitter is provided. The wireless power transmitter includes an amplifier circuit configured to amplify input power, an impedance matching circuit electrically connected to the amplifier circuit, and a resonator configured to receive power from the impedance matching circuit, wherein the resonator may include an annular shaped structure, a plurality of conductors arranged in a loop shape along the structure, and a plurality of capacitors arranged on a surface facing the center of the annular shaped structure to correspond to the plurality of conductors, respectively, wherein each conductor of the plurality of conductors may be helically arranged along the shape of the structure around the structure, and wherein the plurality of conductors may be adjacent to each other and may be alternatively arranged on the same plane or the same curved surface of the structure.

In accordance with another aspect of the disclosure, a wireless power transmitter is provided. The wireless power transmitter includes an amplifier circuit configured to amplify input power, an impedance matching circuit electrically connected to the amplifier circuit, and a resonator configured to receive power from the impedance matching circuit, wherein the resonator may include a structure including an upper surface, a lower surface, an outer surface, and an inner surface and arranged along an annular shape, a plurality of conductors arranged on the structure, and a plurality of capacitors arranged on the inner surface of the structure to correspond to the plurality of conductors, respectively, and wherein each conductor of the plurality of conductors may include a first section arranged on the upper surface of the structure, a second section extending from the first section and arranged on the outer surface of the structure, a third section extending from the second section and arranged on the lower surface of the structure, and a fourth section extending from the third section and arranged on the inner surface of the structure, among the plurality of conductors, a first section of a first conductor, a first section of a second conductor, a first section of a third conductor, and a first section of a fourth conductor may be sequentially arranged along the upper surface of the structure, and among the plurality of conductors, a second section of the second conductor, a second section of the third conductor, a second section of the fourth conductor, and a second section of the first conductor may be sequentially arranged along the outer surface of the structure.

Advantageous Effects

An annular resonator and a wireless power transmitter including an annular resonator according to various embodiments may be advantageous in that the annular resonator includes multiple conductors, and power is distributed and supplied to respective conductors, thereby reducing the size of an electric field generated near the resonator.

An annular resonator and a wireless power transmitter including an annular resonator according to various embodiments may be advantageous in that the annular resonator includes multiple conductors, and the multiple conductors helically intersect with each other so as to form a loop, thereby reducing the size of an electric field generated near the resonator, and guaranteeing that the electric field is generated in a desired direction.

An annular resonator and a wireless power transmitter including an annular resonator according to various embodiments may be advantageous in that the annular resonator includes multiple conductors, the multiple conductors helically intersect with each other so as to form a loop, and a capacitor is connected in a range in which each conductor is positioned on the inner surface of the annular resonator, thereby reducing the size of an electric field generated near the resonator, and guaranteeing that the electric field is generated in a desired direction.

Other aspects, advantages, and salient features of the disclosure will become apparent to those skilled in the art from the following detailed description, which, taken in conjunction with the annexed drawings, discloses various embodiments of the disclosure.

## BRIEF DESCRIPTION OF DRAWINGS

The above and other aspects, features, and advantages of certain embodiments of the disclosure will be more apparent from the following description taken in conjunction with the accompanying drawings, in which:

    FIG. 1 is a circuit diagram illustrating a wireless power transmitter and a wireless power receiver according to an embodiment of the disclosure;
    FIG. 2A is a diagram illustrating a wireless power transmitter including an annular resonator according to an embodiment of the disclosure;
    FIG. 2B is a diagram illustrating a wireless power transmitter including an annular resonator according to an embodiment of the disclosure;
    FIG. 2C is a diagram illustrating a wireless power transmitter including an annular resonator according to an embodiment of the disclosure;
    FIG. 3 is a perspective diagram illustrating an annular resonator according to an embodiment of the disclosure;
    FIG. 4 is a diagram illustrating an arrangement of a conductor in an annular resonator according to an embodiment of the disclosure;
    FIG. 5A is a diagram illustrating an arrangement of a conductor in an annular resonator according to an embodiment of the disclosure;
    FIG. 5B is a perspective diagram illustrating an annular resonator according to an embodiment of the disclosure;
    FIG. 6A is a diagram illustrating a cross-section of an annular resonator according to an embodiment of the disclosure;
    FIG. 6B is a diagram illustrating a cross-section of an annular resonator according to an embodiment of the disclosure;
    FIG. 7 is a diagram illustrating an arrangement of a conductor in an annular resonator according to an embodiment of the disclosure;
    FIG. 8 is a diagram illustrating an arrangement of a conductor in an annular resonator according to an embodiment of the disclosure;
    FIG. 9 is a diagram illustrating an arrangement of a conductor in an annular resonator according to an embodiment of the disclosure;
    FIG. 10 is a diagram illustrating an arrangement of a magnetic member in an annular resonator according to an embodiment of the disclosure;
    FIG. 11 is a diagram illustrating an arrangement of a magnetic member in an annular resonator according to an embodiment of the disclosure;
    FIGS. 12A and 12B are diagrams illustrating a circuit structure of a wireless power transmitter including an annular resonator according to various embodiments of the disclosure;
    FIGS. 13A and 13B are diagrams illustrating a circuit structure of a wireless power transmitter including an annular resonator according to various embodiments of the disclosure;
    FIG. 14 is a perspective diagram illustrating an annular resonator according to an embodiment of the disclosure;
    FIG. 15 is a graph comparing magnitudes of electric fields according to shapes of annular resonators according to an embodiment of the disclosure;
    FIGS. 16A, 16B, 16C, and 16D are diagrams illustrating an electric field distribution according to a shape of an annular resonator according to various embodiments of the disclosure;
    FIG. 17 is a graph comparing magnitudes of electric fields according to shapes of annular resonators according to an embodiment of the disclosure;
    FIG. 18 is a diagram illustrating distribution of an electric field according to a shape of an annular resonator according to an embodiment of the disclosure; and
    FIG. 19 is a graph comparing magnitudes of electric fields according to shapes of annular resonators according to an embodiment of the disclosure.

Throughout the drawings, it should be noted that like reference numbers are used to depict the same or similar elements, features, and structures.

## MODE FOR CARRYING OUT THE INVENTION

The following description with reference to the accompanying drawings is provided to assist in a comprehensive understanding of various embodiments of the invention as defined by the claims. It includes various specific details to assist in that understanding but these are to be regarded as merely exemplary. In addition, descriptions of well-known functions and constructions may be omitted for clarity and conciseness.

The terms and words used in the following description and claims are not limited to the bibliographical meanings, but, are merely used by the inventor to enable a clear and consistent understanding of the disclosure. Accordingly, it should be apparent to those skilled in the art that the following description of various embodiments of the disclosure is provided for illustration purpose only and not for the purpose of limiting the invention as defined by the appended claims.

It is to be understood that the singular forms "a," "an," and "the" include plural referents unless the context clearly dictates otherwise. Thus, for example, reference to "a component surface" includes reference to one or more of such surfaces.

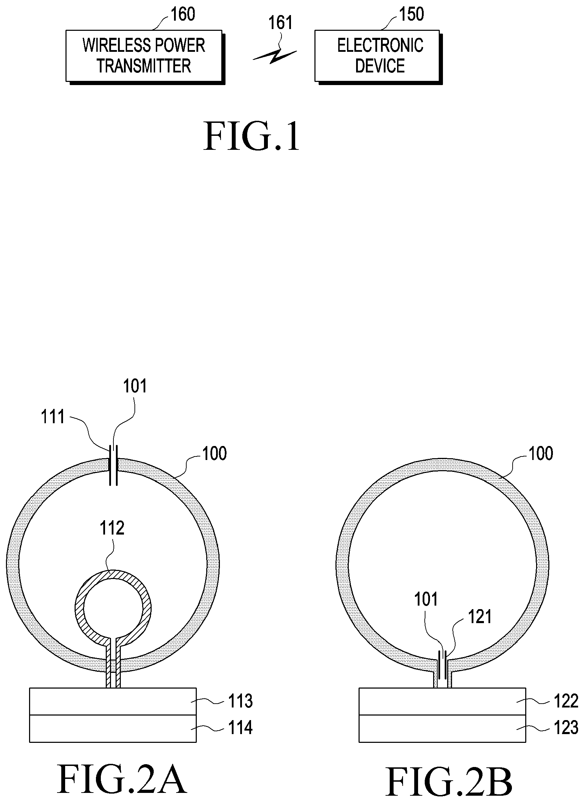

FIG. 1 is a circuit diagram illustrating a wireless power transmitter and a wireless power receiver according to an embodiment of the disclosure.

Referring to FIG. 1, a wireless power transmitter 160 (e.g., an electronic device) according to various embodiments may wirelessly transmit power 161 to a wireless power receiver 150 (hereinafter, referred to as an "electronic device 150" or an "external electronic device"). The wireless power transmitter 160 may transmit the power 161 to the electronic device 150 according to various charging methods. For example, the wireless power transmitter 160 may transmit the power 161 according to an induction method. When the wireless power transmitter 160 operates in an inductive manner, the wireless power transmitter 160 may include, for example, a power source, a direct current-alternate current (DC-AC) conversion circuit, an amplifier circuit, an impedance matching circuit, at least one capacitor, at least one coil, a communication modulation/demodulation circuit, and the like. The at least one capacitor may constitute a resonance circuit together with the at least one coil. The wireless power transmitter 160 may operate in a manner defined in a wireless power consortium (WPC) standard (or Qi standard).

For example, the wireless power transmitter 160 may transmit the power 161 according to a resonance method. In the case of the resonance method, the wireless power transmitter 160 may include, for example, a power source, a DC-AC conversion circuit, an amplifier circuit, an impedance matching circuit, at least one capacitor, at least one resonator or coil, an out-band communication circuit (e.g., a Bluetooth low energy (BLE) communication circuit), and the like. The at least one capacitor and the at least one resonator or coil may constitute a resonant circuit. The wireless power transmitter 160 may operate in a manner defined in an alliance for wireless power (A4WP) standard (or an air fuel alliance (AFA) standard). The wireless power transmitter 160 may include a resonator or coil capable of generating an induced magnetic field when a current flows according to the resonance method or the induction method. A process in which the wireless power transmitter 160 generates an induced magnetic field may be expressed as wireless transmission of the power 161 by the wireless power transmitter 160. In addition, the electronic device 150 may include a coil in which an induced electromotive force is generated by a magnetic field which is formed around the electronic device 150. Here, the size of the magnetic field changes over time. A process in which the electronic device 150 generates an induced electromotive force (i.e., voltage) through a resonator or a coil may be expressed as wireless reception of the power 161 by the electronic device 150.

The wireless power transmitter 160 according to various embodiments of the disclosure may communicate with the electronic device 150. For example, the wireless power transmitter 160 may communicate with the electronic device 150 according to an in-band method. The wireless power transmitter 160 or the electronic device 150 may change a load (or impedance) in response to data to be transmitted, for example, according to an on/off keying modulation method. The wireless power transmitter 160 or the electronic device 150 may measure a load change (or impedance change) based on a change in the magnitude of current, voltage, or power of the resonator or coil, thereby confirming data to be transmitted from a counterpart device.

For example, the wireless power transmitter 160 may communicate with the electronic device 150 according to an out-band (or out-of-band) method. The wireless power transmitter 160 or the electronic device 150 may transmit/receive data using a short-range communication module (e.g., a BLE communication module) provided separately from a resonator, a coil, or a patch antenna.

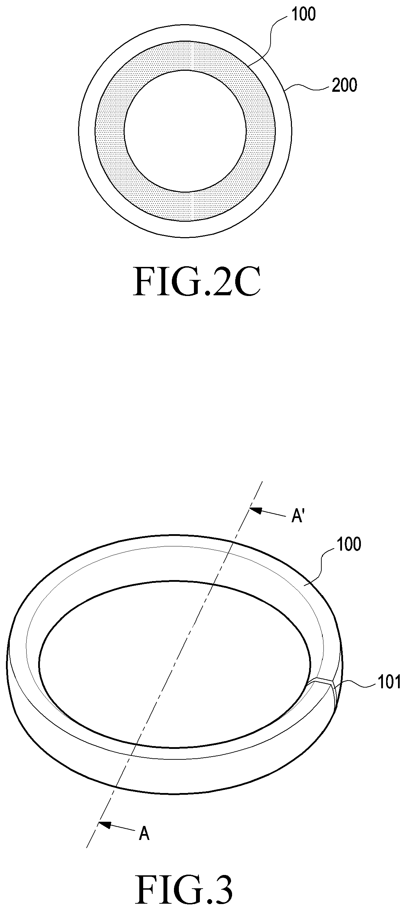

According to various embodiments, the resonator or coil constituting the resonance circuit of the wireless power transmitter 160 may be configured as an annular resonator 100 as shown in FIGS. 2A, 2B, and 2C.

FIGS. 2A, 2B, and 2C are diagrams illustrating a wireless power transmitter including an annular resonator according to various embodiments of the disclosure. Referring to FIG. 2A, the wireless power transmitter may include an amplifier circuit 114, an impedance matching circuit 113, a feeding loop 112, and an annular resonator 100. The wireless power transmitter may amplify power to be transmitted through the amplifying circuit 114, and may then transmit the amplified power to the feeding loop 112 through the impedance matching circuit 113. The feeding loop 112 may form a magnetic field by a supplied current, and the annular resonator 100 may be electromagnetically coupled to the feeding loop 112 to be magnetically induced. The annular resonator 100 may transmit power to the wireless power receiver by forming a magnetic field by the power induced through the coupling with the feeding loop 112. A slit 101 may be provided on one side of the annular resonator 100, and a capacitor 111 may be added to the slit 101. According to various embodiments, the impedance matching circuit 113 may include a feeding coil and a matching capacitor.

Referring to FIG. 2B, the wireless power transmitter may include the amplifier circuit 123, the impedance matching circuit 122, and the annular resonator 100. The wireless power transmitter may amplify power to be transmitted through the amplification circuit 123, and may then transmit the amplified power to the annular resonator 100 through the impedance matching circuit 122. The annular resonator 100 may transmit power to the wireless power receiver by forming a magnetic field by a current supplied from the impedance matching circuit 122. The slit 101 may be provided on one side of the annular resonator 100, and a capacitor 121 may be connected to both ends of an annular shaped structure at which the slit 101 is provided. According to various embodiments, the capacitor 121 may be included in the impedance matching circuit 122. According to various embodiments, the impedance matching circuit 122 may include a feeding coil and a matching capacitor.

Although the annular resonator 100 in FIGS. 2A and 2B described above is disposed vertically with respect to the ground, according to various embodiments, the annular resonator 100 in FIG. 2C may be disposed horizontally with respect to the ground. For example, referring to FIG. 2C, the annular resonator 100 may be disposed horizontally with respect to the ground, and a magnetic member 200 (or a shielding member) may be disposed under the annular resonator 100. The magnetic member 200 may be made of a metal, a magnetic material such as ferrite, a nanocrystal, or a material having the same or similar properties, but is not limited thereto.

FIG. 3 is a perspective diagram illustrating an annular resonator according to an embodiment of the disclosure. Referring to FIG. 3, the resonator 100 that can be applied to the wireless power transmitter 160 may be constituted of an annular shaped structure. In the annular shaped structure, as shown in FIG. 3, a side surface facing a central portion (e.g., a hollow portion) from the surface of the annular shaped structure may be defined as an inner surface of the annular shaped structure with respect to the A-A' axis, and a side surface facing to the outside from the surface of the annular shaped structure may be defined as an outer surface of the annular shaped structure. The slit 101 may be provided on at least a portion of the annular shaped structure, and the slit 101 may function as a capacitor. When the annular shaped structure is connected to a circuit unit of the wireless power transmitter 160, the annular shaped structure may be connected to the circuit unit through both ends of the annular shaped structure at which the slit 101 is provided. A capacitor may be connected to both ends of the annular shaped structure at which the slit 101 is provided. According to various embodiments, a conductor may be provided on the surface of the annular shaped structure. When a current is supplied to both ends at which the slit 101 is provided in the annular shaped structure, a high frequency may be transmitted through the surface of the annular shaped structure.

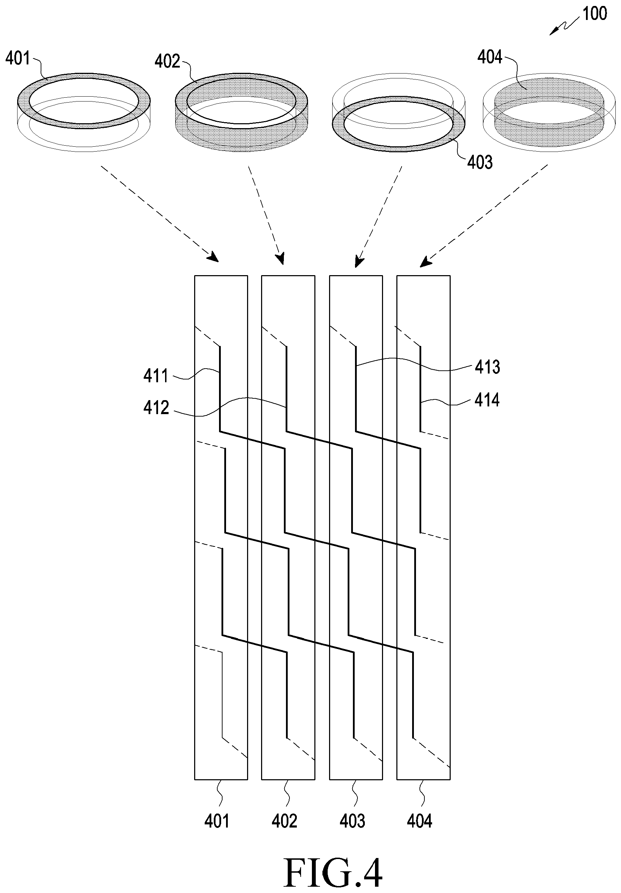

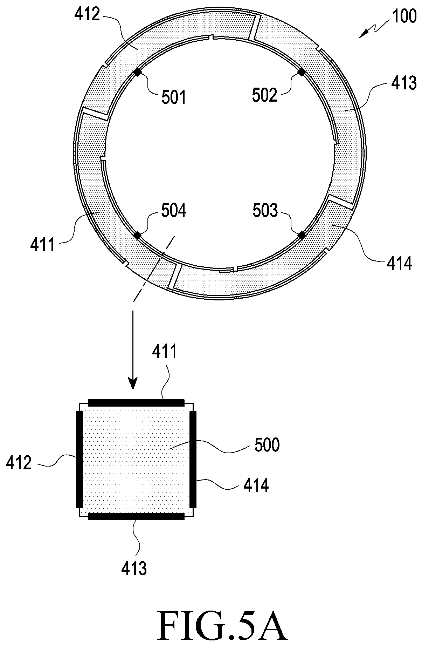

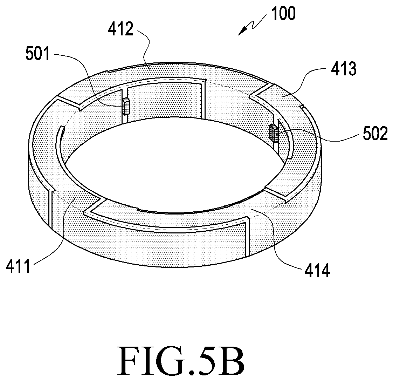

FIGS. 4, 5A, and 5B are diagrams illustrating an arrangement of a conductor in an annular resonator according to various embodiments of the disclosure.

Referring to FIGS. 4, 5A, and 5B, the structure of the annular resonator 100 may be provided in a shape surrounded by an upper surface 401, an outer surface 402, a lower surface 403, and an inner surface 404. According to various embodiments, the cross-section of the structure of the annular resonator 100 may be configured in a circular, elliptical, or polygonal shape. When the cross-section of the structure of the annular resonator 100 is configured in the circular or elliptical shape, and the structure of the annular resonator 100 may be provided in a shape surrounded by the outer surface 402 and the inner surface 404 while the upper surface 401 and the lower surface 403 are omitted. Embodiments of FIGS. 4, 5A, and 5B to be described later illustrate a case in which the cross-section of the structure of the annular resonator 100 has a quadrangle, but various embodiments are not limited to the quadrangle.

According to various embodiments, at least one conductor may be disposed on the surface of the structure of the annular resonator 100.

FIG. 4 is a diagram illustrating an arrangement of a conductor in an annular resonator according to an embodiment of the disclosure.

For example, referring to FIG. 4, a first conductor 411, a second conductor 412, a third conductor 413, and a fourth conductor 414 may be arranged on the surface of the structure of the annular resonator 100. The conductors 411, 412, 413, and 414 may be respectively arranged in a loop shape along the structure. According to various embodiments, each of the conductors 411, 412, 413, and 414 may be arranged on the upper surface 401 of the structure in a first section, may be arranged on the outer surface 402 of the structure in a second section extending from the first section, may be arranged on the lower surface 403 of the structure in a third section extending from the second section, and may be arranged on the inner surface 404 of the structure in a fourth section extending from the third section. According to the arrangement as described above, each of the conductors 411, 412, 413, and 414 may be helically arranged along the shape of the structure on the surface of the structure. For example, the plurality of conductors 411, 412, 413, and 414 may be arranged adjacent to each other, and may be alternately arranged on the same plane (e.g., the upper surface 401, the outer surface 402, the lower surface 403, or the inner surface 404) or the same curved surface of the structure.

According to various embodiments, among the plurality of conductors, a first section of the first conductor 411, a first section of the second conductor 412, a first section of the third conductor 413, and a first section of the fourth conductor 414 may be sequentially arranged along the upper surface 401 of the structure. Among the plurality of conductors, a second section of the first conductor 411, a second section of the second conductor 412, a second section of the third conductor 413, and a second section of the fourth conductor 414 may be sequentially arranged along the outer surface 402 of the structure. Among the plurality of conductors, a third section of the first conductor 411, a third section of the second conductor 412, a third section of the third conductor 413, and a third section of the fourth conductor 414 may be sequentially arranged along the lower surface 403 of the structure. Among the plurality of conductors, a fourth section of the first conductor 411, a fourth section of the second conductor 412, a fourth section of the third conductor 413, and a fourth section of the fourth conductor 414 may be sequentially arranged along the inner surface 404 of the structure.

According to various embodiments, each of the conductors 411, 412, 413, and 414 is shown in the form of a line in FIG. 4, but may have a predetermined thickness as shown in FIGS. 5A and 5B. According to various embodiments, each of the conductors 411, 412, 413, and 414 may include copper, but is not limited thereto, and any material capable of being electrically connected may be included in the conductors 411, 412, 413, and 414.

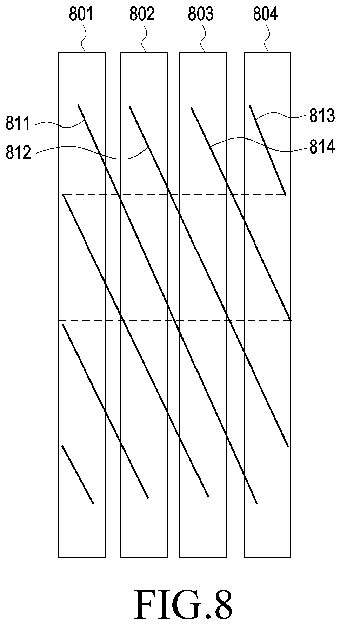

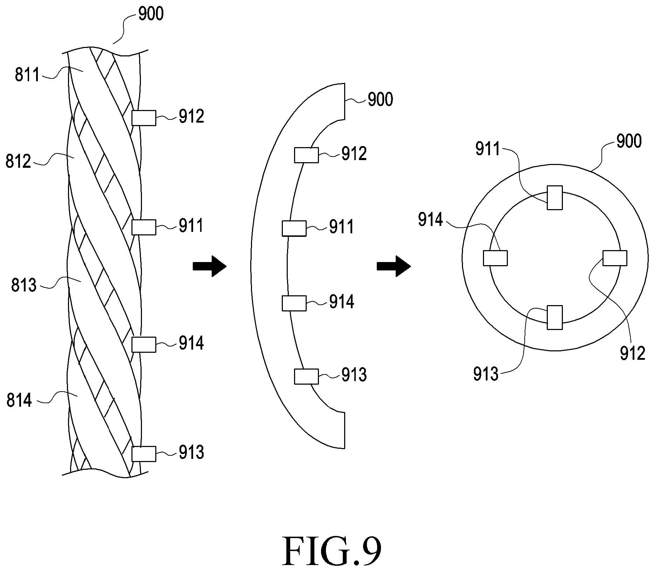

According to various embodiments, in FIGS. 4, 5A, and 5B, the sections of the conductors 411, 412, 413, and 414 may be displayed as being abruptly changed at a predetermined angle at a specific location, but may be implemented as being gradually changed as will be described later in FIGS. 8 and 9. For example, each of the conductors 411, 412, 413, and 414 may be configured in the form of a twisted line. In FIG. 4, the four conductors 411, 412, 413, and 414 are shown to be alternately arranged with each other, but according to various embodiments, two, three, or five or more conductors may be alternately arranged with each other.

According to various embodiments, as shown in FIG. 4, the plurality of conductors 411, 412, 413, and 414 constituting the annular resonator 100 may be provided and power may be distributed and supplied to each of the conductors 411, 412, 413, and 414, thereby reducing the magnitude of an electric field generated in the vicinity of the resonator. According to various embodiments, as shown in FIG. 4, the plurality of conductors 411, 412, 413, and 414 may helically cross each other to form a loop, thereby reducing the magnitude of the electric field generated in the vicinity of the resonator and enabling the electric field to be generated in a desired direction.

FIG. 5A is a diagram illustrating an arrangement of a conductor in an annular resonator according to an embodiment of the disclosure.

FIG. 5B is a perspective diagram illustrating an annular resonator according to an embodiment of the disclosure.

According to various embodiments, referring to FIGS. 5A and 5B, each of the conductors 411, 412, 413, and 414 may be connected to at least one capacitor 501, 502, 503, and 504. For example, at least a portion of each of the conductors 411, 412, 413, and 414 may form a slit, and the capacitors 501, 502, 503, and 504 may be added or connected to the slit. According to various embodiments, the capacitors 501, 502, 503, and 504 may be arranged on the inner surface 404 of the structure of the annular resonator 100. For example, the first capacitor 501 may be arranged in a fourth section in which the first conductor 411 passes through the inner surface 404, the second capacitor 502 may be arranged in a fourth section in which the second conductor 412 passes through the inner surface 404, the third capacitor 503 may be arranged in a fourth section in which the third conductor 413 passes through the inner surface 404, and the fourth capacitor 504 may be arranged in a fourth section in which the fourth conductor 414 passes through the inner surface 404. According to various embodiments, the plurality of capacitors 501, 502, 503, and 504 may be arranged such that a separation distance therebetween is greater than or equal to a predetermined distance or a maximum. For example, when the four capacitors 501, 502, 503, and 504 are arranged on the inner surface 404 as shown in FIGS. 5A and 5B, the fourth capacitors 501, 502, 503, and 504 may be arranged at an angle of 90 degrees from the center of the annular shaped structure 100, respectively. As another example, when five capacitors are arranged on the inner surface 404, they may be arranged at an angle of 72 degrees from the center of the annular structure 100, respectively, and when six capacitors are arranged on the inner surface 404, they may be arranged at an angle of 60 degrees from the center of the annular shaped structure 100, respectively.

According to various embodiments, as shown in FIGS. 5A and 5B, the capacitors 501, 502, 503, and 504 may be arranged in or connected to a section (e.g., the fourth section) in which each of the conductors 411, 412, 413, and 414 is located on the inner surface 404 of the annular resonator 100, thereby reducing the magnitude of the electric field generated in the vicinity of the annular resonator 100 and enabling the electric field to be generated in a desired direction. For example, as shown in FIGS. 5A and 5B, the capacitors 501, 502, 503, and 504 may be arranged in a section (e.g., the fourth section) in which each of the conductors 411, 412, 413, and 414 is located on the inner surface 404 of the annular resonator 100, so that an electric field may be formed in a direction of an inner side or a hollow portion of the annular resonator 100 and a relatively smaller amount of an electric field may be formed on an outer side of the annular resonator 100.

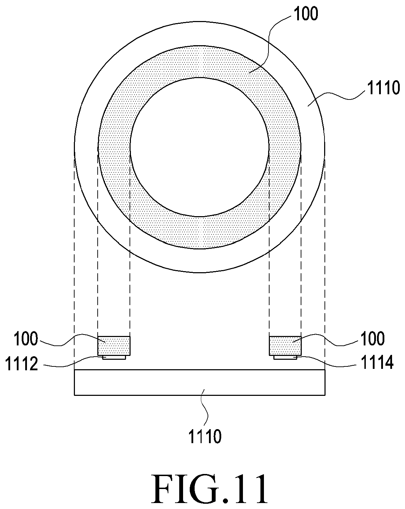

According to various embodiments, unlike shown in FIGS. 5A and 5B (e.g., as shown in FIG. 11), the capacitors 501, 502, 503, and 504 may be arranged in or connected to a section (e.g., the third section) in which each of the conductors 411, 412, 413, and 414 is located on the lower surface 403 of the annular resonator 100, thereby reducing the magnitude of the electric field generated in the vicinity of the annular resonator 100 and enabling a relatively smaller amount of an electric field to be generated outside the annular resonator 100.

According to various embodiments, as shown in FIG. 5A, the cross-section of the structure of the annular resonator 100 may be formed in a quadrangular shape. An interior 500 of the structure may be filled with a dielectric material or filled with air. In the above-described embodiments, it has been described that the conductors 511, 512, 513, and 514 are arranged on the surface of the structure of the annular resonator 100, but the plurality of conductors 511, 512, 513, and 514 may constitute the annular resonator 100 of FIGS. 4, 5A, and 5B without the structure.

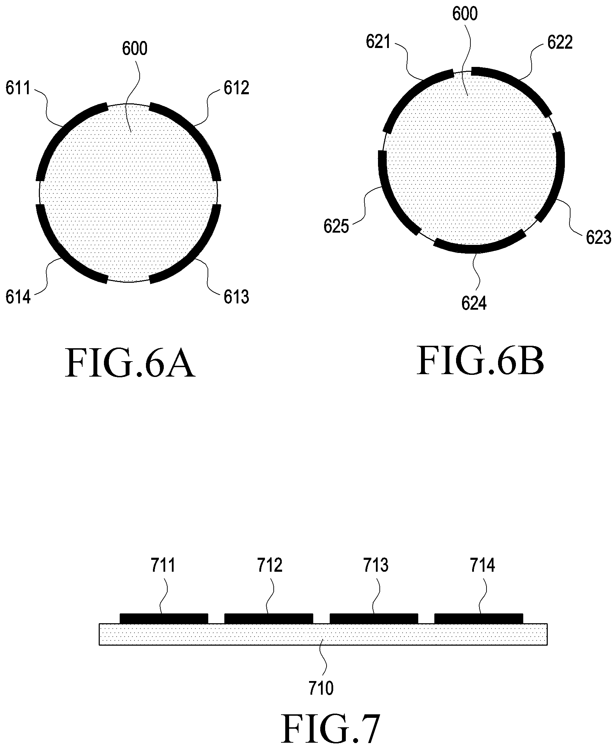

FIGS. 6A and 6B are diagrams illustrating a cross-section of an annular resonator according to various embodiments of the disclosure. Although the cross-section of the annular resonator 100 is illustrated in a quadrangle in FIGS. 4, 5A, and 5B, the annular resonator 100 may have a circular or oval shape as shown in FIGS. 6A and 6B. According to various embodiments, the cross-section of the annular resonator 100 may be provided in a shape in which the curvatures of the outer surface and the inner surface are different from each other.

According to various embodiments, in the embodiment of FIG. 6A, an example in which four conductors (e.g., a first conductor 611, a second conductor 612, a third conductor 613, and a fourth conductor 614) are arranged on the surface of the structure is illustrated. According to various embodiments, referring to FIG. 6A, each of the conductors 611, 612, 613, and 614 may be respectively arranged in a loop shape along the structure. According to the arrangement as described above, each of the conductors 611, 612, 613, and 614 may be helically arranged along the shape of the structure on the surface of the structure. For example, the plurality of conductors 611, 612, 613, and 614 may be arranged adjacent to each other, and may be alternately arranged on the same curved surface of the structure.

According to various embodiments, in the embodiment of FIG. 6B, an example in which five conductors (e.g., a first conductor 621, a second conductor 622, a third conductor 623, a fourth conductor 624, and a fifth conductor 625) are arranged on the surface of the structure is illustrated. According to various embodiments, referring to FIG. 6B, the conductors 621, 622, 623, 624, and 625 may be respectively arranged in a loop shape along the structure. According to the arrangement as described above, each of the conductors 621, 622, 623, 624, and 625 may be helically arranged along the shape of the structure on the surface of the structure. For example, the plurality of conductors 621, 622, 623, 624, and 625 may be arranged adjacent to each other, and may be alternately arranged on the same curved surface of the structure. FIGS. 6A and 6B illustrate that four or five conductors are arranged on the surface of the structure, but according to various embodiments, two, three, or six or more conductors may be arranged on the surface of the structure. FIGS. 6A and 6B illustrate that the cross-section of the structure of the annular resonator 100 is provided in a circular shape, but according to various embodiments, the cross-section of the structure of the annular resonator 100 may be configured in an oval shape and may be configured in a shape in which the curvatures of the outer surface and the inner surface are different from each other.

According to various embodiments, an interior 600 of the structure may be filled with a dielectric material or filled with air. In the above-described embodiments, it is described that the conductors 611, 612, 613, 614, 621, 622, 623, 624, are 625 are arranged on the surface of the structure of the annular resonator 100, but the plurality of conductors 611, 612, 613, 614, 621, 622, 623, 624, and 625 may constitute the annular resonator 100 of FIGS. 6A and 6B without the structure.

FIG. 7 is a diagram illustrating an arrangement of a conductor in an annular resonator according to an embodiment of the disclosure.

Referring to FIG. 7, each of a plurality of conductors 711, 712, 713, and 714 may be arranged on a printed circuit board (PCB) 710. According to various embodiments, when the PCB is provided in a circular shape, the annular resonator 100 may be configured in the form of FIG. 6A described above.

FIG. 8 is a diagram illustrating an arrangement of a conductor in an annular resonator according to an embodiment of the disclosure, and FIG. 9 is a diagram illustrating an arrangement of a conductor in an annular resonator according to an embodiment of the disclosure.

Referring to FIGS. 8 and 9, the structure of the annular resonator 100 may be provided in a shape surrounded by an upper surface 801, an outer surface 802, a lower surface 803, and an inner surface 804. According to various embodiments, the cross-section of the structure of the annular resonator 100 may be provided in a circular, elliptical, or polygonal shape. When the cross-section of the structure of the annular resonator 100 is provided in a circular or elliptical shape, the structure of the annular resonator 100 may be provided in a shaped surrounded by the outer surface 802 and the inner surface 804 while the upper surface 801 and the lower surface 803 are omitted.

According to various embodiments, at least one conductor may be arranged on the surface of the structure of the annular resonator 100. For example, referring to FIG. 8, a first conductor 811, a second conductor 812, a third conductor 813, and a fourth conductor 814 may be arranged on the surface of the structure of the annular resonator 100. The conductors 811, 812, 813, and 814 may be respectively arranged in a loop shape along the structure. According to various embodiments, each of the conductor 811, 812, 813, 814 may be arranged on the upper surface 801 of the structure in a first section, may be arranged on the outer surface 802 of the structure in a second section extending from the first section, may be arranged on the lower surface 803 of the structure in a third section extending from the second section, and may be arranged on the inner surface 804 of the structure in a fourth section extending from the third section. According to the arrangement as described above, each of the conductors 811, 812, 813, and 814 may be helically arranged along the shape of the structure on the surface of the structure as shown in FIG. 9. For example, the plurality of conductors 811, 812, 813, and 814 may be arranged adjacent to each other, and may be alternatively arranged on the same plane (e.g., the upper surface 801, the outer surface 802, the lower surface 803, and the inner surface 804) of the structure or the same curved surface thereof.

According to various embodiments, among the plurality of conductors, a first section of the first conductor 811, a first section of the second conductor 812, a first section of the third conductor 813, and a first section of the fourth conductor 814 may be sequentially arranged along the upper surface 801 of the structure. Among the plurality of conductors, a second section of the first conductor 811, a second section of the second conductor 812, a second section of the third conductor 813, and a second section of the fourth conductor 814 may be sequentially arranged along the outer surface 802 of the structure. Among the plurality of conductors, a third section of the first conductor 811, a third section of the second conductor 812, a third section of the third conductor 813, and a third section of the fourth conductor 814 may be sequentially arranged along the lower surface 803 of the structure. Among the plurality of conductors, a fourth section of the first conductor 811, a fourth section of the second conductor 812, a fourth section of the third conductor 813, and a fourth section of the fourth conductor 814 may be arranged sequentially along the inner surface 804 of the structure.

According to various embodiments, each of the conductors 811, 812, 813, and 814 is shown in the form of a line in FIG. 8, but may have a predetermined thickness as shown in FIG. 9. According to various embodiments, each of the conductors 811, 812, 813, and 814 may include copper, but is not limited thereto, and any material capable of being electrically connected may be included in the conductors 811, 812, 813, and 814.

According to various embodiments, referring to FIGS. 8 and 9, the section of each conductor 811, 812, 813, and 814 may be implemented to be gradually changed. For example, each of the conductors 811, 812, 813, and 814 may be provided in the form of a twisted line as shown in FIG. 9. In FIGS. 8 and 9, the four conductors 811, 812, 813, and 814 are illustrated as being alternately arranged with each other, but according to various embodiments, two, three, or five or more conductors may be alternatively arranged with each other.

According to various embodiments, referring to FIG. 9, capacitors 911, 912, 913, and 914 may be added or arranged in at least a portion of each of the conductors 811, 812, 813, and 814. According to various embodiments, after each of the conductors 811, 812, 813, and 814 is provided in the form of a twisted line, an annular resonator 900 may be provided in such a manner that the capacitors 911, 912, 913, and 914 are bent to face the inner surface, as shown in FIG. 9.

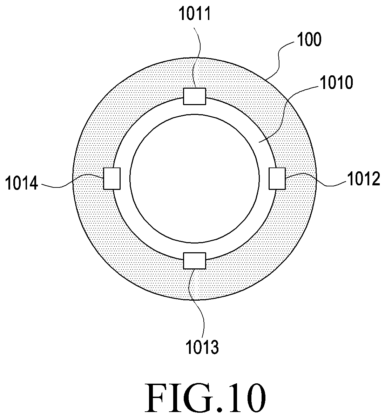

FIG. 10 is a diagram illustrating an arrangement of a magnetic member in an annular resonator according to an embodiment of the disclosure. Referring to FIG. 10, at least one capacitor 1011, 1012, 1013, and 1014 may be arranged on the inner surface of the annular resonator 100 as described above. When the at least one capacitor 1011, 1012, 1013, and 1014 is arranged on the inner surface of the annular resonator 100, a relatively larger amount of an electric field may be formed in a direction from the inner surface of the annular resonator 100 to a central portion (e.g., a hollow portion) thereof. When various components are arranged in the central portion of the annular resonator 100, the electric field may be affected. According to various embodiments, a magnetic member 1010 may be disposed to prevent an effect of an electric field formed in the central portion of the annular resonator 100. The magnetic member 1010 may be made of a metal, a magnetic material such as ferrite, a nanocrystal, or a material having the same or similar properties, but is not limited thereto.

FIG. 11 is a diagram illustrating an arrangement of a magnetic member in an annular resonator according to an embodiment of the disclosure. Referring to FIG. 11, at least one capacitor 1112 and 1114 may be arranged under the annular resonator 100 as described above. When the at least one capacitor 1112 and 1114 are arranged under the annular resonator 100, a relatively larger amount of an electric field may be formed in a downward direction of the annular resonator 100. When various components are arranged under the annular resonator 100, the electric field may be affected. According to various embodiments, the magnetic member 1110 may be disposed under the annular resonator 100 to prevent an effect of the electric field formed under the annular resonator 100. The magnetic member 1110 may be made of a metal, a magnetic material such as ferrite, a nanocrystal, or a material having the same or similar properties, but is not limited thereto. According to various embodiments, although not shown in FIG. 11, a housing or a support member for fixing or supporting the annular resonator 100 or the magnetic member 1110 may be further included.

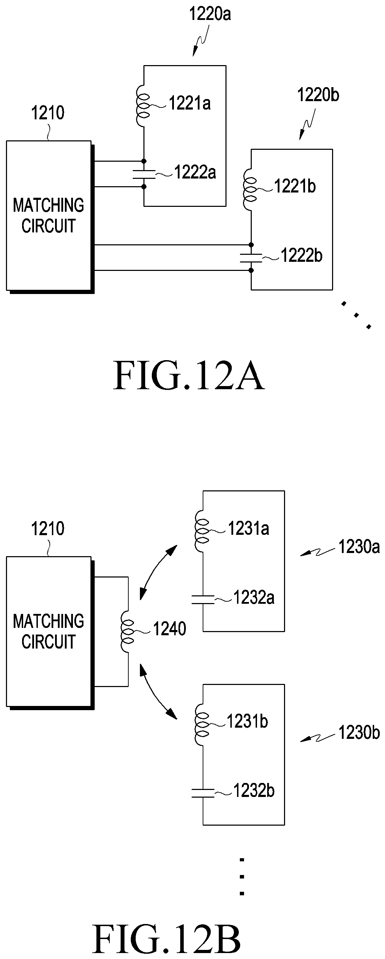

FIGS. 12A and 12B are diagrams illustrating a circuit structure of a wireless power transmitter including an annular resonator according to various embodiments of the disclosure.

Referring to FIG. 12A, a plurality of conductors illustrated in FIGS. 4, 5A, 5B, 6A, 6B, and 7 to 11 may be connected in parallel to a matching circuit 1210, respectively. For example, a plurality of resonators (or conductors) may be respectively connected to the matching circuit 1210 (e.g., an impedance matching circuit). In FIG. 12A, two resonators 1220a and 1220b are illustrated as being respectively connected in parallel to the matching circuit 1210, but according to various embodiments, three or more resonators may be further connected in parallel to the matching circuit 1210. For example, the first resonator 1220a may include a first conductor 1221a (e.g., a first coil) and a first capacitor 1222a, and the second resonator 1220b may include a second conductor 1221b (e.g., a second coil) and a second capacitor 1222b.

According to various embodiments, assuming that an inductance of the first conductor 1221a of the first resonator 1220a is $L_1$, a capacitance $C_1$ of the first capacitor 1222a may be configured as shown in Equation 1 below.

[Equation 1]

$$C_1 = \frac{1}{(2\pi f_1)^2 \times L_1}$$

Assuming that an inductance of the second conductor 1221b of the second resonator 1220b is $L_2$, a capacitance $C_2$ of the second capacitor 1222b may be configured as shown in Equation 2 below.

[Equation 2]

$$C_2 = \frac{1}{(2\pi f_2)^2 \times L_2}$$

According to various embodiments, design frequencies $f_1$ and $f_2$ of closed-loop resonators 1220a and 1220b may be designed to be greater than an operating frequency $f_o$ of the wireless power transmitter. For example, since the inductance of each of the closed-loop resonators 1220a and 1220b increases by the sum of self-inductance and mutual inductance due to coupling of the adjacent closed-loop resonators 1220a and 1220b, the resonant frequencies $f_1$ and $f_2$ formed by the self-inductance of each of the closed-loop resonators 1220a and 1220b and the capacitors 1222a and 1222b may be higher than the resonant frequency $f_o$ when all the closed-loop resonators 1220a and 1220b operate.

Referring to FIG. 12B, the plurality of conductors illustrated in FIGS. 4, 5A, 5B, 6A, 6B, and 7 to 11 may be coupled to the matching circuit 1210 through a feeding loop coil 1240, respectively. For example, the plurality of resonators (or conductors) may be magnetically inductively coupled to the matching circuit 1210 (e.g., an impedance matching circuit), respectively.

Although the two resonators 1230a and 1230b are shown as magnetically inductively coupled to the feeding loop coil 1240 of the matching circuit 1210 in FIG. 12B, according to various embodiments, three or more resonators may be further magnetically inductively coupled thereto. For example, the first resonator 1230a may include a first conductor 1231a (e.g., a first coil) and a first capacitor 1232a, and the second resonator 1230b may include a second conductor 1231b (e.g., a second coil) and a second capacitor 1232b.

According to various embodiments, power received from the feeding loop coil 1240 connected to the matching circuit 1210 may be magnetically induced in the first conductor 1231a of the first resonator 1230a and the second conductor 1231b of the second resonator 1230b that are inductively coupled to the feeding loop coil 1240.

According to various embodiments, assuming that an inductance of the first conductor 1231a of the first resonator 1230a is $L_1$, a capacitance $C_1$ of the first capacitor 1232a may be configured to be the same as or similar to the above-mentioned Equation 1. Assuming that an inductance of the second conductor 1231b of the second resonator 1230b is $L_2$, a capacitance $C_2$ of the second capacitor 1232b may be configured to be the same as or similar to Equation 2 described above.

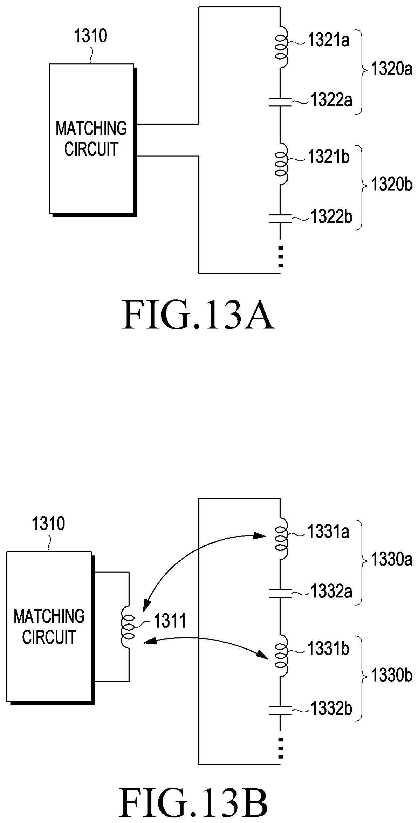

FIGS. 13A and 13B are diagrams illustrating a circuit structure of a wireless power transmitter including an annular resonator according to various embodiments of the disclosure.

Referring to FIG. 13A, a plurality of resonators 1320a illustrated in FIGS. 4, 5A, 5B, 6A, 6B, and 7 to 11 may be connected in series to a matching circuit 1310, respectively. For example, a plurality of resonators (or conductors) may be connected in series to the matching circuit 1310 (e.g., an impedance matching circuit). In FIG. 13A, two resonators 1320a and 1320b are illustrated as being respectively connected in parallel to the matching circuit 1310, but according to various embodiments, three or more resonators may be further connected in series to the matching circuit 1310. For example, the first resonator 1320a may include a first conductor 1321a (e.g., a first coil) and a first capacitor 1322a, and the fourth resonator 1320b may include a fourth conductor 1321b (e.g., a fourth coil) and a fourth capacitor 1322b.

According to various embodiments, as shown in FIG. 13A, one end of each resonator may be connected to one end of another resonator, and a plurality of resonators may be connected in series to form one loop. For example, referring to FIG. 13A, one end 1' of the first resonator 1320a may be connected to one end 4 of the fourth resonator 1320b.

Referring to FIG. 13B, the plurality of conductors illustrated in FIGS. 4, 5A, 5B, 6A, 6B, and 7 to 11 may be respectively coupled to the matching circuit 1310 through a feeding loop coil 1311. For example, a plurality of resonators (or conductors) may be magnetically inductively coupled to the matching circuit 1310 (e.g., an impedance matching circuit).

Although the two resonators 1330a and 1330b are illustrated as being magnetically inductively coupled to the feeding loop coil 1311 of the matching circuit 1310 in FIG. 13B, according to various embodiments, three or more resonators may be further magnetically inductively coupled thereto. For example, the first resonator 1330a may include a first conductor 1331a (e.g., a first coil) and a first capacitor 1332a, and the fourth resonator 1330b may include a fourth conductor 1331b (e.g., a fourth coil) and a fourth capacitor 1332b.

According to various embodiments, power received from the feeding loop coil 1311 connected to the matching circuit 1310 may be magnetically induced in the first conductor 1331a of the first resonator 1330a and the fourth conductor 1331b of the fourth resonator 1330b that are inductively coupled to the feeding loop coil 1311.

According to various embodiments, as shown in FIG. 13B, one end of each resonator may be connected to one end of another resonator, and a plurality of resonators may be connected in series to form one loop. For example, referring to FIG. 13B, one end 1' of the first resonator 1330a may be connected to one end 4 of the fourth resonator 1330b.

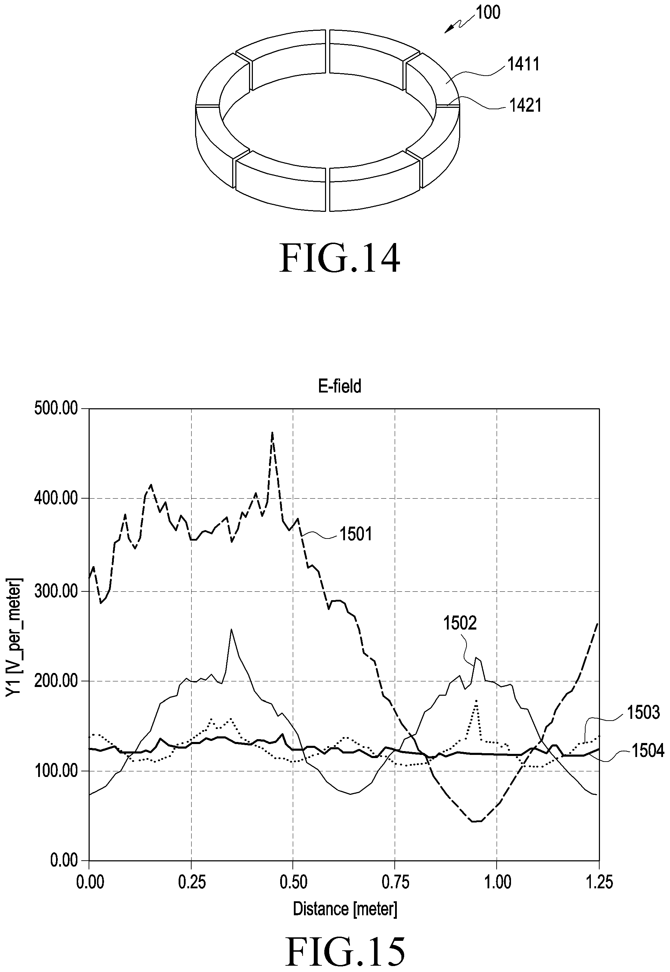

FIG. 14 is a perspective diagram illustrating an annular resonator according to an embodiment of the disclosure.

Referring to FIG. 14, the annular resonator may be divided into a plurality of conductors 1411 sequentially separated by gaps 1421, and the plurality of conductors 1411 may be connected to each other by a capacitor.

FIG. 15 is a graph comparing magnitudes of electric fields according to shapes of annular resonators according to an embodiment of the disclosure.

FIG. 15 illustrates a magnitude 1501 of an electric field according to a distance when the resonator shown in FIG. 14 is provided with one conductor, a magnitude 1502 of an electric field according to a distance when the resonator is divided into two conductors, a magnitude 1503 of an electric field according to a distance when the resonator is divided into four conductors, and a magnitude 1504 of an electric field according to a distance when the resonator is divided into eight conductors.

According to various embodiments, referring to FIG. 15, when the resonator is divided into the plurality of conductors and the capacitor is connected between the conductors, a relatively low electric field may be formed compared to a case where the resonator is configured as a single conductor.

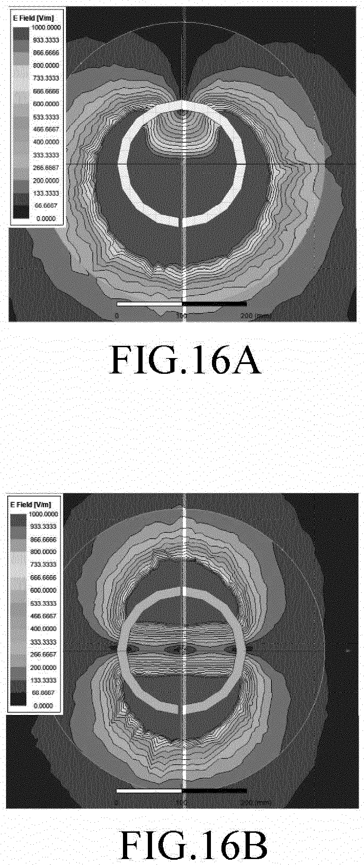

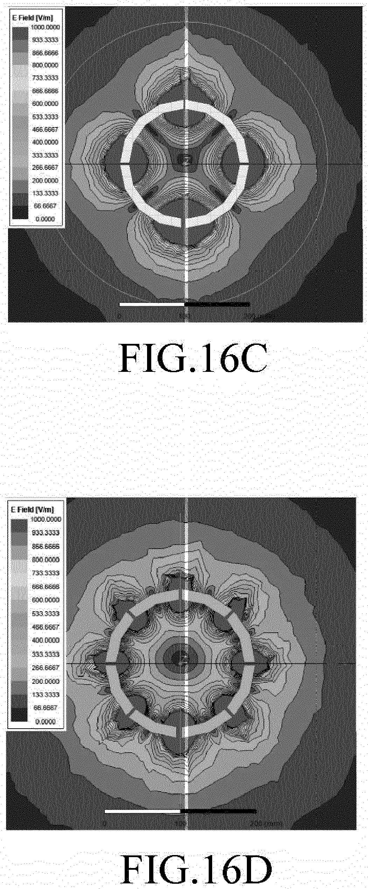

FIGS. 16A, 16B, 16C, and 16D are diagrams illustrating distribution of an electric field according to the shape of an annular resonator according to various embodiments of the disclosure. FIG. 16A illustrates distribution of an electric field when the annular resonator of FIG. 14 is provided with one conductor, FIG. 16B illustrates distribution of an electric field when the resonator is divided into two conductors, FIG. 16C illustrates distribution of an electric field when the resonator is divided into four conductors, and FIG. 16D illustrates distribution of an electric field when the resonator is divided into eight conductors. As the resonator is divided into a plurality of conductors, the magnitude of the electric field may be relatively reduced and the magnitude of the electric field formed on the outer surface of the resonator may be reduced.

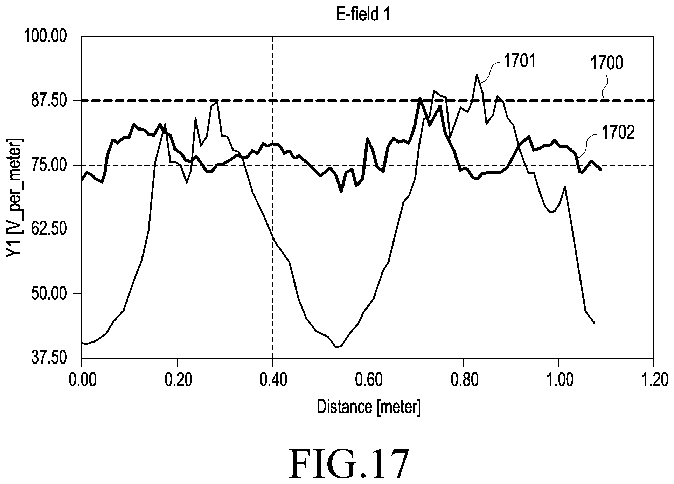

FIG. 17 is a graph comparing magnitudes of electric fields according to shapes of annular resonators according to an embodiment of the disclosure. Referring to FIG. 17, compared to a magnitude 1701 when an annular resonator is divided into two conductors, it can be seen that a magnitude of an electric field 1702 when four conductors are helically arranged as shown in FIGS. 5A and 5B is relatively lowered and a stable shape is shown according to a corresponding distance. For example, when a reference value 1700 according to the electric field regulation is configured to be 87.50 V/m, or when the annular resonator is divided into two conductors, a distance that does not satisfy the reference value 1700 according to the electric field regulation may occur. However, when the four conductors are arranged helically as shown in FIGS. 5B and 5B, it can be seen that the reference value 1700 according to the electric field regulation is satisfied over the entire distance.

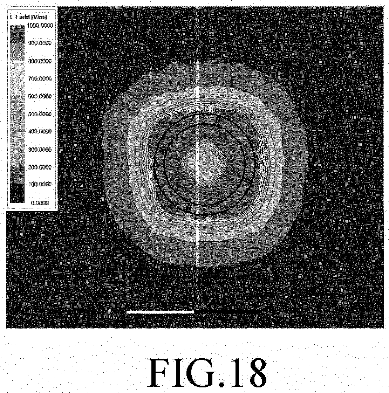

FIG. 18 is a diagram illustrating distribution of an electric field according to the shape of an annular resonator according to an embodiment of the disclosure. Referring to FIG. 18, according to various embodiments, when four conductors are helically arranged as shown in FIGS. 5A and 5B, it can be seen that the magnitude of the electric field is relatively reduced compared to FIG. 16A, and the magnitude of the electric field formed on the outer surface of the resonator is reduced.

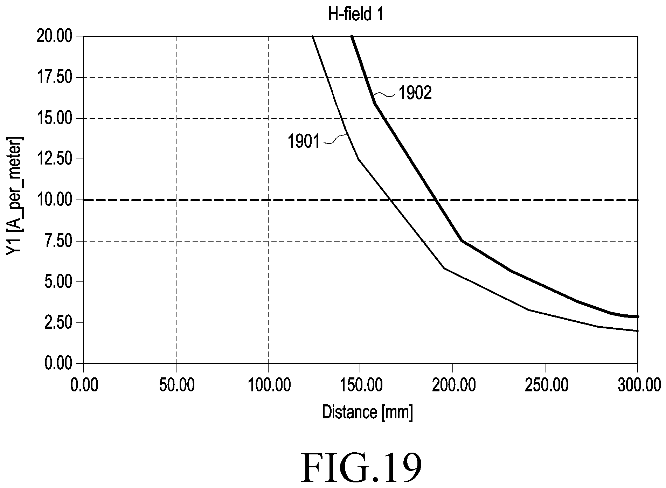

FIG. 19 is a graph comparing magnitudes of electric fields according to shapes of annular resonators according to an embodiment of the disclosure. Referring to FIG. 19, according to various embodiments, it can be seen that a magnitude 1902 of a magnetic field when four conductors are helically arranged as in FIGS. 5A and 5B is generated larger at the same distance than a magnitude 1901 of the magnetic field in the arrangement as shown in FIG. 16A and the magnetic field of the same magnitude reaches a greater distance. For example, as shown in FIG. 19, a distance at which the magnetic field is lowered to 10.00 A/m may be 164.89 mm in the arrangement as in FIG. 16A, but according to various embodiments, when four conductors are helically arranged as shown in FIGS. 5A and 5B, it can be confirmed that the same magnetic field is generated up to a position further apart as 190.16 mm.

A resonator according to any one of various embodiments may include a structure including an upper surface, a lower surface, an outer surface, and an inner surface and arranged along an annular shape, a plurality of conductors arranged on the structure, and a plurality of capacitors connected to the plurality of conductors, respectively, wherein each conductor of the plurality of conductors may include a first section disposed on the upper surface of the structure, a second section extending from the first section and disposed on the outer surface of the structure, a third section extending from the second section and disposed on the lower surface of the structure, and a fourth section extending from the third section and disposed on the inner surface of the structure, among the plurality of conductors, a first section of a first conductor, a first section of a second conductor, a first section of a third conductor, and a first section of a fourth conductor may be sequentially arranged along the upper surface of the structure, and among the plurality of conductors, a second section of the second conductor, a second section of the third conductor, a second section of the fourth conductor, and a second section of the first conductor may be sequentially arranged along the outer surface of the structure.

According to various embodiments, the plurality of capacitors may be disposed respectively in the fourth section of each conductor.

According to various embodiments, the resonator may further include a magnetic member disposed in a hollow portion of the resonator.

According to various embodiments, the plurality of capacitors are disposed respectively in a slit in the fourth section of each conductor.

According to various embodiments, the plurality of capacitors may be disposed respectively in the third section of each conductor.

According to various embodiments, the resonator may further include a magnetic member disposed under the plurality of capacitors.

According to various embodiments, the plurality of capacitors may be arranged such that a distance between two adjacent capacitors among the plurality of capacitors is greater than or equal to a predetermined distance.

According to various embodiments, a cross-section of the structure may be provided in a form of at least one of a circle, an ellipse, or a polygon.

According to various embodiments, curvatures of the outer surface and the inner surface are different from each other.

According to various embodiments, at least a portion or an inner side of the structure may include a dielectric.

According to various embodiments, an interior of the structure is filled with a dielectric material or filled with air.

According to various embodiments, one end of the first conductor among the plurality of conductors may be connected to one end of the fourth conductor.

According to various embodiments, each conductor of the plurality of conductors may be electrically connected to an impedance matching circuit including a feeding coil and a matching capacitor, and may receive power from the impedance matching circuit.

According to various embodiments, each conductor of the plurality of conductors may be spaced apart from an impedance matching circuit including a feeding coil and a matching capacitor, and may receive power through inductive coupling with the impedance matching circuit.

A resonator according to any one of various embodiments may include an annular shaped structure, a plurality of conductors arranged in a loop shape along the structure, respectively, and a plurality of capacitors arranged on a surface facing the center of the annular shaped structure to correspond to the plurality of conductors, respectively, wherein each conductor of the plurality of conductors may be helically arranged along the shape of the structure around the structure, and the plurality of conductors may be adjacent to each other and may be alternatively arranged on the same plane or the same curved surface of the structure.

According to various embodiments, the resonator may further include a magnetic member disposed in a hollow portion of the resonator.

According to various embodiments, the plurality of capacitors may be arranged such that a distance between two adjacent capacitors among the plurality of capacitors is greater than or equal to a predetermined distance.

According to various embodiments, the cross-section of the structure may be provided in the form of at least one of a circle, an ellipse, or a polygon.

According to various embodiments, at least a portion or an inner side of the structure may include a dielectric.

According to various embodiments, one end of the first conductor among the plurality of conductors may be connected to one end of another conductor.

According to various embodiments, each conductor of the plurality of conductors may be electrically connected to an impedance matching circuit including a feeding coil and a matching capacitor, and may receive power from the impedance matching circuit.

A wireless power transmitter according to any one of various embodiments may include an amplifier circuit configured to amplify input power, an impedance matching circuit electrically connected to the amplifier circuit, and a resonator configured to receive power from the impedance matching circuit, wherein the resonator may include an annular shaped structure, a plurality of conductors arranged in a loop shape along the structure, and a plurality of capacitors arranged on a surface facing the center of the annular shaped structure to correspond to the plurality of conductors, respectively, wherein each conductor of the plurality of conductors may be helically arranged along the shape of the structure around the structure, and wherein the plurality of conductors may be adjacent to each other and may be alternatively arranged on the same plane or the same curved surface of the structure.

A wireless power transmitter according to any one of various embodiments may include an amplifier circuit configured to amplify input power, an impedance matching circuit electrically connected to the amplifier circuit, and a resonator configured to receive power from the impedance matching circuit, wherein the resonator may include a structure including an upper surface, a lower surface, an outer surface, and an inner surface and arranged along an annular shape, a plurality of conductors arranged on the structure, and a plurality of capacitors arranged on the inner surface of the structure to correspond to the plurality of conductors, respectively, and wherein each conductor of the plurality of conductors may include a first section arranged on the upper surface of the structure, a second section extending from the first section and arranged on the outer surface of the structure, a third section extending from the second section and arranged on the lower surface of the structure, and a fourth section extending from the third section and arranged on the inner surface of the structure, among the plurality of conductors, a first section of a first conductor, a first section of a second conductor, a first section of a third conductor, and a first section of a fourth conductor may be sequentially arranged along the upper surface of the structure, and among the plurality of conductors, a second section of the second conductor, a second section of the third conductor, a second section of the fourth conductor, and a second section of the first conductor may be sequentially arranged along the outer surface of the structure.

A resonator according to any one of various embodiments may include a printed circuit board; a plurality of conductors arranged on the printed circuit board to collectively comprise a circular configuration; and a plurality of capacitors arranged on the printed circuit board to correspond to the plurality of conductors, respectively.

It should be appreciated that various embodiments of the disclosure and the terms used therein are not intended to limit the technological features set forth herein to particular embodiments and include various changes, equivalents, or alternatives for a corresponding embodiment. With regard to the description of the drawings, similar reference numerals may be used to designate similar or relevant elements. A singular form of a noun corresponding to an item may include one or more of the items, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one or all possible combinations of the items enumerated together in a corresponding one of the phrases. As used herein, such terms as "a first," "a second," "the first," and "the second" may be used to simply distinguish a corresponding element from another, and does not limit the elements in other aspect (e.g., importance or order). It is to be understood that if an element (e.g., a first element) is referred to, with or without the term "operatively" or "communicatively," as "coupled with/to" or "connected with/to" another element (e.g., a second element), it means that the element may be coupled/connected with/to the other element directly (e.g., wiredly), wirelessly, or via a third element.

According to various embodiments, each element (e.g., module or program) of the above-described elements may include a single entity or multiple entities, and some of the multiple entities may be separately disposed in any other element. According to various embodiments, one or more of the above-described elements may be omitted, or one or more other elements may be added. Alternatively or additionally, a plurality of elements (e.g., modules or programs) may be integrated into a single element. In such a case, according to various embodiments, the integrated element may still perform one or more functions of each of the plurality of elements in the same or similar manner as they are performed by a corresponding one of the plurality of elements before the integration. According to various embodiments, operations performed by the module, the program, or another element may be carried out sequentially, in parallel, repeatedly, or heuristically, or one or more of the operations may be executed in a different order or omitted, or one or more other operations may be added.

**Claims**

1. A resonator comprising:

   a structure including an upper surface, a lower surface, an outer surface, and an inner surface and arranged along an annular shape;
   a plurality of conductors, arranged on the structure; and
   a plurality of capacitors connected to the plurality of conductors, respectively,
   wherein each conductor of the plurality of conductors includes a first section disposed on the upper surface of the structure, a second section extending from the first section and disposed on the outer surface of the structure, a third section extending from the second section and disposed on the lower surface of the structure, and a fourth section extending from the third section and disposed on the inner surface of the structure,
   wherein, among the plurality of conductors, a first section of a first conductor, a first section of a second conductor, a first section of a third conductor, and a first section of a fourth conductor are sequentially arranged along the upper surface of the structure, and
   wherein, among the plurality of conductors, a second section of the second conductor, a second section of the third conductor, a second section of the fourth conductor, and a second section of the first conductor are sequentially arranged along the outer surface of the structure.

2. The resonator of claim 1, wherein the plurality of capacitors are disposed respectively in the fourth section of each conductor.

3. The resonator of claim 2, further comprising:
   a magnetic member disposed in a hollow portion of the resonator.

4. The resonator of claim 2, wherein the plurality of capacitors are disposed respectively in a slit in the fourth section of each conductor.

5. The resonator of claim 1, wherein the plurality of capacitors are disposed respectively in the third section of each conductor.

6. The resonator of claim 5, further comprising:
   a magnetic member disposed under the plurality of capacitors.

7. The resonator of claim 1, wherein, the plurality of capacitors are arranged such that a distance between two adjacent capacitors among the plurality of capacitors is greater than or equal to a predetermined distance.

8. The resonator of claim 1, wherein a cross-section of the structure is in a form of at least one of a circle, an ellipse, or a polygon.

9. The resonator of claim 8, wherein curvatures of the outer surface and the inner surface are different from each other.

10. The resonator of claim 1, wherein at least a portion or an inner side of the structure includes a dielectric.

11. The resonator of claim 1, wherein an interior of the structure is filled with a dielectric material or filled with air.

12. The resonator of claim 1, wherein one end of the first conductor among the plurality of conductors is connected to one end of the fourth conductor.

13. The resonator of claim 1, wherein each conductor of the plurality of conductors is electrically connected to an impedance matching circuit including a feeding coil and a matching capacitor, and receives power from the impedance matching circuit.

14. The resonator of claim 1, wherein each conductor of the plurality of conductors is spaced apart from an impedance matching circuit including a feeding coil and a matching capacitor, and receives power through inductive coupling with the impedance matching circuit.

**Patentansprüche**

1. Resonator, umfassend:

eine Struktur, die eine obere Fläche, eine untere Fläche, eine äußere Fläche und eine innere Fläche beinhaltet und entlang einer ringförmigen Form vorgesehen ist;
eine Vielzahl von Leitern, die auf der Struktur vorgesehen ist; und
eine Vielzahl von Kondensatoren, die jeweils mit der Vielzahl von Leitern verbunden ist,
wobei jeder Leiter der Vielzahl von Leitern einen ersten Teilabschnitt, der auf der oberen Fläche der Struktur angeordnet ist, einen zweiten Teilabschnitt, der sich von dem ersten Teilabschnitt erstreckt und auf der äußeren Fläche der Struktur angeordnet ist, einen dritten Teilabschnitt, der sich von dem zweiten Teilabschnitt erstreckt und auf der unteren Fläche der Struktur angeordnet ist, und einen vierten Teilabschnitt, der sich von dem dritten Teilabschnitt erstreckt und auf der inneren Fläche der Struktur angeordnet ist, beinhaltet,
wobei unter der Vielzahl von Leitern ein erster Teilabschnitt eines ersten Leiters, ein erster Teilabschnitt eines zweiten Leiters, ein erster Teilabschnitt eines dritten Leiters und ein erster Teilabschnitt eines vierten Leiters aufeinanderfolgend entlang der oberen Fläche der Struktur vorgesehen sind und
wobei unter der Vielzahl von Leitern ein zweiter Teilabschnitt des zweiten Leiters, ein zweiter Teilabschnitt des dritten Leiters, ein zweiter Teilabschnitt des vierten Leiters und ein zweiter Teilabschnitt des ersten Leiters aufeinanderfolgend entlang der äußeren Fläche der Struktur vorgesehen sind.

2. Resonator nach Anspruch 1, wobei die Vielzahl von Kondensatoren jeweils in dem vierten Teilabschnitt jedes Leiters angeordnet ist.

3. Resonator nach Anspruch 2, ferner umfassend: ein magnetisches Element, das in einem hohlen Abschnitt des Resonators angeordnet ist.

4. Resonator nach Anspruch 2, wobei die Vielzahl von Kondensatoren jeweils in einem Schlitz in dem vierten Teilabschnitt jedes Leiters angeordnet ist.

5. Resonator nach Anspruch 1, wobei die Vielzahl von Kondensatoren jeweils in dem dritten Teilabschnitt jedes Leiters angeordnet ist.

6. Resonator nach Anspruch 5, ferner umfassend: ein magnetisches Element, das unter der Vielzahl von Kondensatoren angeordnet ist.

7. Resonator nach Anspruch 1, wobei die Vielzahl von Kondensatoren derart vorgesehen ist, dass eine Entfernung zwischen zwei benachbarten Kondensatoren aus der Vielzahl von Kondensatoren größer als eine vorbestimmte Entfernung oder gleich dieser ist.

8. Resonator nach Anspruch 1, wobei ein Querschnitt der Struktur in einer Form von mindestens einem von einem Kreis, einer Ellipse oder einem Polygon vorliegt.

9. Resonator nach Anspruch 8, wobei sich Krümmungen der äußeren Fläche und der inneren Fläche voneinander unterscheiden.

10. Resonator nach Anspruch 1, wobei mindestens ein Abschnitt oder eine Innenseite der Struktur ein Dielektrikum beinhaltet.

11. Resonator nach Anspruch 1, wobei ein Innenbereich der Struktur mit einem dielektrischen Material gefüllt ist oder mit Luft gefüllt ist.

12. Resonator nach Anspruch 1, wobei ein Ende des ersten Leiters aus der Vielzahl von Leitern mit einem Ende des vierten Leiters verbunden ist.

13. Resonator nach Anspruch 1, wobei jeder Leiter der Vielzahl von Leitern elektrisch mit einer Impedanzanpassungsschaltung verbunden ist, die eine Einspeisespule und einen Anpassungskondensator beinhaltet, und Leistung von der Impedanzanpassungsschaltung empfängt.

14. Resonator nach Anspruch 1, wobei jeder Leiter der Vielzahl von Leitern von einer Impedanzanpassungsschaltung, die eine Einspeisespule und einen Anpassungskondensator beinhaltet, beabstandet ist und Leistung durch induktive Kopplung mit der Impedanzanpassungsschaltung empfängt.

**Revendications**

1. Résonateur comprenant :

une structure comprenant une surface supérieure, une surface inférieure, une surface externe et une surface interne et agencée le long d'une forme annulaire ;
une pluralité de conducteurs, agencés sur la structure ; et
une pluralité de condensateurs connectés à la pluralité de conducteurs, respectivement, dans lequel chaque conducteur de la pluralité de conducteurs comprend une première section disposée sur la surface supérieure de la structure, une deuxième section s'étendant à partir de la première section et disposée sur la surface externe de la structure, une troisième section s'étendant à partir de la deuxième section et disposée sur la surface inférieure de la structure, et une quatrième section s'étendant à partir de la troisième section et disposée sur la surface interne de la structure,
dans lequel, parmi la pluralité de conducteurs, une première section d'un premier conducteur, une première section d'un deuxième conducteur, une première section d'un troisième conducteur et une première section d'un quatrième conducteur sont agencées séquentiellement le long de la surface supérieure de la structure, et

dans lequel, parmi la pluralité de conducteurs, une deuxième section du deuxième conducteur, une deuxième section du troisième conducteur, une deuxième section du quatrième conducteur et une deuxième section du premier conducteur sont agencées séquentiellement le long de la surface externe de la structure.

2. Résonateur de la revendication 1, dans lequel la pluralité de condensateurs sont disposés respectivement dans la quatrième section de chaque conducteur.

3. Résonateur de la revendication 2, comprenant en outre :
un élément magnétique disposé dans une partie creuse du résonateur.

4. Résonateur de la revendication 2, dans lequel la pluralité de condensateurs sont disposés respectivement dans une fente dans la quatrième section de chaque conducteur.

5. Résonateur de la revendication 1, dans lequel la pluralité de condensateurs sont disposés respectivement dans la troisième section de chaque conducteur.

6. Résonateur de la revendication 5, comprenant en outre :
un élément magnétique disposé sous la pluralité de condensateurs.

7. Résonateur de la revendication 1, dans lequel la pluralité de condensateurs sont agencés de sorte qu'une distance entre deux condensateurs adjacents parmi la pluralité de condensateurs est supérieure ou égale à une distance prédéterminée.

8. Résonateur de la revendication 1, dans lequel une section transversale de la structure se présente sous une forme d'au moins l'un d'un cercle, d'une ellipse ou d'un polygone.

9. Résonateur de la revendication 8, dans lequel des courbures de la surface externe et de la surface interne sont différentes l'une de l'autre.

10. Résonateur de la revendication 1, dans lequel au moins une partie ou un côté interne de la structure comprend un diélectrique.

11. Résonateur de la revendication 1, dans lequel un intérieur de la structure est rempli d'un matériau diélectrique ou rempli d'air.

12. Résonateur de la revendication 1, dans lequel une extrémité du premier conducteur parmi la pluralité de conducteurs est connectée à une extrémité du quatrième conducteur.

13. Résonateur de la revendication 1, dans lequel chaque conducteur de la pluralité de conducteurs est électriquement connecté à un circuit d'adaptation d'impédance comprenant une bobine d'alimentation et un condensateur d'adaptation, et reçoit de l'énergie à partir du circuit d'adaptation d'impédance.

14. Résonateur de la revendication 1, dans lequel chaque conducteur de la pluralité de conducteurs est espacé d'un circuit d'adaptation d'impédance comprenant une bobine d'alimentation et un condensateur d'adaptation, et reçoit de l'énergie par couplage inductif avec le circuit d'adaptation d'impédance.

FIG.1

FIG.2A

FIG.2B

FIG.2C

FIG.3

FIG.4

FIG.5A

FIG.5B

600

611       612

614       613

## FIG.6A

600

621       622

625       623

624

## FIG.6B

711     712     713     714

710

## FIG.7

FIG.8

FIG.9

FIG.10

FIG.11

FIG.12A

FIG.12B

FIG.13A

FIG.13B

FIG.14

FIG.15

FIG.16A

FIG.16B

## FIG.16C

## FIG.16D

FIG.17

FIG.18

FIG.19

**EP 4 346 006 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2011193415 A1
- WO 2021154836 A1
- US 2017186527 A1
- JP 2019192691 A